# DEMANDE DE BREVET EUROPEEN

(11) **EP 0 650 185 A1**
(43) Date de publication de la demande: **26.04.1995**
(21) Numéro de dépôt: 94402306.8
(22) Date de dépôt: 14.10.1994
(51) Int. Cl.: H01L 21/027, H01L 21/331, H01L 21/285

(54) **Procédé d'obtention de contacts conducteurs auto-alignés pour composants électroniques**

(30) Priorité: 18.10.1993 FR 9312354
(71) Demandeur: FRANCE TELECOM, F-75015 Paris (FR)
(72) Inventeur: Etrillard, Jackie, F-78730 St Arnoult en Yvelines (FR)
(74) Mandataire: Dubois-Chabert, Guy

(57) **Abrégé**

Selon ce procédé, on forme, sur un substrat (2) destiné à porter le composant, une couche inférieure (4) et, sur celle-ci, une structure (6, 8) dont une partie comporte une ouverture et surplombe la couche inférieure, on grave cette dernière de façon anisotrope à travers l'ouverture, on dépose une première couche (36) sur l'ensemble résultant des étapes précédentes, on élimine ladite structure puis la couche inférieure, et on dépose au moins une deuxième couche conductrice(40) dont une partie se dépose sur le substrat et constitue un contact du composant, un autre contact résultant d'un dépôt conducteur (34) préalablement au dépôt de la première couche ou du dépôt de celle-ci alors choisie conductrice.

## Description

La présente invention concerne un procédé d'obtention de contacts conducteurs, ou électrodes, auto-alignés pour composants électroniques.

Par "composants électroniques", on entend aussi bien des composants électroniques unitaires, destinés à être utilisés individuellement, que des circuits intégrés.

L'invention permet de réaliser des électrodes auto-alignées sur des dispositifs semiconducteurs comme par exemple les transistors unipolaires, les transistors bipolaires et les diodes.

L'invention s'applique notamment à la fabrication de circuits logiques rapides, de circuits hyperfréquences et de circuits micro-opto-électroniques.

Le procédé objet de l'invention permet
- de réduire les éléments parasites (les capacités parasites par exemple) des composants fabriqués et
- de diminuer le nombre d'étapes lithographiques nécessaires à la réalisation des composants.

Il en résulte une diminution des coûts de fabrication de ces composants et une augmentation du rendement de fabrication et de la fiabilité des composants.

Il existe un très grand nombre de procédés permettant l'auto-alignement des contacts de composants électroniques.

Le but recherché est de simplifier l'enchaînement des étapes de réalisation et, surtout, de réduire les dimensions critiques des composants en s'affranchissant des problèmes de précision d'alignement de leurs différents niveaux.

Cette réduction des dimensions est indispensable à un accroissement des performances des composants.

On présente ci-après les diverses méthodes connues pour réaliser un auto-alignement.

La méthode la plus fréquemment utilisée, notamment en microélectronique sur silicium, met en oeuvre des espaceurs.

Ces derniers sont obtenus par des dépôts conformes de matériaux électriquement isolants (silice ou nitrure de silicium par exemple) généralement effectués par PECVD (pour "Plasma Enhanced Chemical Vapor Deposition).

Schématiquement, la démarche consiste, après dépôt conforme d'un isolant réalisé sur un contact, ou électrode, métallique de section rectangulaire, à graver cet isolant d'une manière anisotrope.

La vitesse de gravure, qui est constante sur les différentes zones du motif obtenu, permet de laisser en place les parties de l'isolant déposées sur les flancs de l'électrode.

Ces parties constituent les espaceurs.

L'électrode métallique se trouve alors encapsulée dans un isolant.

L'auto-alignement est ensuite effectué : il suffit de déposer une couche métallique sur l'ensemble obtenu pour contacter les autres parties actives du composant.

Cette méthode est à présent très largement utilisée en Microélectronique, dans la technologie utilisant le silicium.

Elle est également exposée dans de nombreux articles sur la technologie utilisant des composés III-V.

On consultera à ce sujet les articles suivants :
A new self-alignment technology using bridged base electrode for small-scaled AlGaAs/GaAs HBT's, K. Nagata et al., IEEE trans. on elect. devices, vol.39, n°8, August 1992, p.1786
Emitter size effect on current gain in fully self-aligned AlGaAs/GaAs HBT's with AlGaAs surface passivation layer, N. HAYAMA et al., IEEE electron device letters, vol.11, n°9, Sep. 1990, p.388.

Une seconde méthode, appelée méthode "SAINT", est couramment utilisée dans l'Industrie pour les circuit intégrés III-V.

On consultera à ce sujet le document suivant :
K. YAMASAKI et al., Electronics letters, 4th February 1982, vol.18, n°3, p.119.

Le principe de cette seconde méthode nécessite de maîtriser, avec précision et uniformité sur l'ensemble d'une tranche ("wafer") de semiconducteur, la sur-gravure ("over-etching") d'une structure tricouche.

Cette sur-gravure détermine la longueur de grille d'un transistor à effet de champ (dispositif pour lequel cette méthode est utilisée).

Des circuits VLSI III-V ont été réalisés en utilisant cette méthode.

On consultera à ce sujet le document suivant :
A.I. AKINWANDE et al., IEEE Trans. Electron. Devices, vol.36 n°10, Oct. 1989, p.2204.

D'autres méthodes plus marginales (ou plus récentes et donc peu introduites dans les filières de développement de composants électroniques) ont été décrites.

Une méthode originale utilise la forte fluidité du polyimide pour constituer des espaceurs entre l'émetteur et la base d'un transistor bipolaire.

On consultera à ce sujet le document suivant :
K. MORIZUKA et al., IEEE Electron Device Letters, vol.9, n°11, Nov. 1988, p.598 à 600

Le polyimide comble, lors du "spinning" (centrifugation du polyimide en vue de l'étaler), l'espace résiduel entre l'émetteur et la base obtenu après sur-gravure du mésa d'émetteur et "lift off" des contacts de base.

Le polyimide enrobe ici les contacts de base sur lesquels on vient déposer le contact d'émetteur.

Ce dernier peut être aligné avec une précision moins importante que celle qui serait exigée sans auto-alignement.

L'application à l'intégration de cette méthode originale a été effectuée avec succès (fabrication de diviseurs par 4 à 18 GHz avec un rendement de 60%).

Dans cette méthode, la distance entre l'émetteur et la base est uniquement déterminée par la sur-gravure de l'émetteur sous un motif de masquage composé de silice et de résine photosensible.

A ce sujet on consultera l'article suivant :
Novel process for emitter-base- collector self-aligned heterojunction bipolar transistor using a pattern inversion method, S. TANAKA et al., Electronics Letters, vol.23, n°11, p.562.

Une autre méthode, ayant également débouché sur la fabrication de circuits intégrés, utilise encore une telle sur-gravure de l'émetteur pour contrôler la distance entre l'émetteur et la base.

A ce sujet, on consultera l'article suivant :
AlGaAs/GaAs heterojunction bipolar transistors fabricated using a simple dual-lift-off Process, M.C.F. Chang et al., IEEE electron device letters vol. EDL8 n°7 July 1987, p.303.

Là encore, le contact d'émetteur est déposé par liff-off après un alignement dont la précision est moindre que celle qui est exigée lorsqu'une telle technique n'est pas employée.

Néanmoins, il ne s'agit pas d'un auto-alignement total car le métal du contact d'émetteur peut éventuellement venir se déposer sur l'enrobage diélectrique qui recouvre la base.

C'est encore cette sur-gravure de l'émetteur, mais cette fois au moyen d'une gravure ionique réactive, qui permet, grâce à un contrôle précis des cotes sur-gravées, de réaliser l'auto-alignement réel de l'émetteur sur la base.

La sur-gravure permet d'obtenir un surplomb suffisant pour aligner les contacts de base sur l'émetteur qui reçoit donc les deux métallisations superposées.

A ce sujet on consultera l'article suivant :
Submicron scaling of AlGaAs/GaAs self-aligned thin emitter hererojunction bipolar transitors (SATE-HBT) with current gain independent of emitter area, R.J. MALIK et al., Electronics Letters, 17 Aug. 1989, vol.25 n°17, p.1175.

En ce qui concerne cette méthode de sur-gravure contrôlée, un autre exemple est mentionné dans l'article de S. TANAKA et al. déjà cité plus haut.

Dans ce cas, l'auto-alignement concerne les trois contacts d'un transistor bipolaire.

Cet auto-alignement est également fondé sur la maîtrise de la sur-gravure des mésas d'émetteur et de base (cette gravure étant mixte et consistant en une gravure chimique par voie liquide puis une gravure par voie sèche).

D'autres méthodes d'auto-alignement utilisent la lithographie électronique.

Cette dernière est à la base des performances les plus brillantes obtenues jusqu'à présent sur les composants III-V.

On consultera à ce sujet l'article suivant :
High aspect ratio assymetric gate structures employed in novel self-aligned high electron mobility transistor technology, M.A. THOMSON et al., J. Vac. Sci. Technol. B.8(6) Nov/Dec. 1990, p.1339.

Une méthode d'auto-alignement utilisant la lithographie électronique fut décrite pour la première fois dans le document suivant :
CHAO et al., IEDM Tech. Dig. Washington DC, Dec. 1983, p.613 à 616.

Elle utilise une structure à deux couches ou à trois couches suivant les différentes variantes développées par plusieurs équipes.

Le principe de cette méthode consiste à exploiter la plus grande sensibilité électronique du copolymère P(MMA-co-MAA) vis-à-vis du polymère PMMA pour former une structure en T dans la structure multicouche PMMA-P (MMA-co-MAA)-PMMA.

Cette structure en T est alors métallisée et, après lift-off (dissolution des polymères), donne le contact métallique souhaité.

Les côtés du T permettent l'auto-alignement des contacts de drain et de source dans le cas de transistors unipolaires.

A ce sujet on consultera également l'article suivant :
Developer selection for T-Shaped gate Fet's using PMMA/P[MMA-co-MMA]/PMMA, Ph. A. LAMARE, IEEE Trans. on elect. devices, vol.39, n°38, August 1992.

On indique ci-après les inconvénients des procédés connus précédemment mentionnés.

On considère d'abord les inconvénients des procédés fondés sur les espaceurs.

On considèrera ensuite les inconvénients des procédés d'auto-alignement par sur-gravure.

Enfin, on considèrera les inconvénients des procédés fondés sur les sensibilités différentes des résines électrosensibles.

Les procédés fondés sur les espaceurs présentent deux défauts majeurs.

Le premier de ces défauts est relatif à l'importance non négligeable du temps nécessaire au dépôt des matériaux électriquement isolants.

Ces matériaux, comme par exemple la silice ou le nitrure de silicium, sont en général déposés par PECVD.

Cette technique est la seule qui permette des dépôts conformes.

Ces dépôts se font à température moyenne, de l'ordre de 150°C, sous vide, avec des ions relativement énergétiques qui peuvent induire, au début du dépôt, quelques défauts de surface par désorption ou transfert d'énergie des ions.

Les vitesses de dépôt sont relativement modestes.

De la même manière, les vitesses de gravure, en vue de la constitution des espaceurs, sont assez faibles.

La réalisation des espaceurs est donc une étape coûteuse et éventuellement gênante au niveau des surfaces actives du composant électronique que l'on forme.

Le deuxième défaut des procédés utilisant les espaceurs réside dans le fait que l'enrobage obtenu introduit une capacité parasite entre les deux électrodes dont il est sensé permettre l'auto-alignement.

La valeur de cette capacité formée par les deux contacts métalliques et l'enrobage est estimée à quelques pour-cent de la valeur de la capacité de jonction.

Il peut s'y ajouter les capacités formées par les espaceurs et les parties du contact d'émetteur déposées latéralement.

A ce propos, on consultera par exemple la réalisation décrite dans l'article de K. NAGATA et al. déjà cité plus haut.

Ceci est d'autant plus important que l'épaisseur des espaceurs décroît de bas en haut.

Le diélectrique est d'autant plus mince que l'on se situe plus près du contact d'émetteur.

On conçoit que les pertes puissent être importantes notamment dans les zones proches du contact d'émetteur et que la capacité parasite y soit plus forte que les valeurs estimées dans ces zones pour cette capacité.

Enfin, l'un des derniers inconvénients que l'on puisse évoquer en ce qui concerne l'utilisation d'un diélectrique est que celui-ci favorise, par les défauts qu'il crée en surface, lors de son dépôt et de sa gravure, les recombinaisons de surface des semiconducteurs (notamment des semiconducteurs III-V).

Le courant de fuite dû aux recombinaisons de surface peut, par conséquent, être plus important à cause des étapes qui permettent la réalisation des espaceurs.

On considère maintenant les inconvénients des procédés utilisant un auto-alignement par sur-gravure.

L'inconvénient majeur de tels procédés réside dans les problèmes d'uniformité de la sur-gravure.

Si cette sur-gravure est effectuée par voie humide (gravure chimique) les conditions de reproductibilité et d'uniformité sont difficiles à obtenir :

La composition de la solution de gravure, la température du bain et la mouillabilité du substrat jouent un rôle déterminant sur les cotes de sur-gravure.

Compte tenu des très faibles dimensions envisagées entre les deux contacts (de l'ordre de 0,1 µm à 0,2 µm), il faut scrupuleusement respecter ces conditions si l'on veut obtenir des rendements de fabrication corrects.

Si la sur-gravure est effectuée par voie sèche (gravure plasma), les problèmes rencontrés proviennent de la non-uniformité des procédés de gravure dans les réacteurs.

On peut être confronté
- à des effets locaux de charge (à l'échelle des motifs à graver),
- à des problèmes thermiques (dus par exemple à un refroidissement non uniforme de la tranche de semiconducteur sur laquelle on réalise un composant électronique) et
- à des effets de proximité des parois du réacteur ou des bords du plateau couvre-cathode dans le cas d'une gravure ionique réactive.

Il peut aussi exister des effets de non-uniformité des flancs du masque de résine (ou de tout autre masque choisi).

Cette non-uniformité provient elle-même de la non-uniformité des techniques lithographiques.

On voit donc que les problèmes de non-uniformité et de non-reproductibilité sont nombreux.

Ils interviennent en ce qui concerne le rendement de fabrication mais aussi les performances des composants électroniques formés.

En effet, les résistances d'accès aux zones actives de ces composants dépendent de la distance de sur-gravure.

Si cette distance est trop importante, les performances s'en ressentent.

Il existe encore un inconvénient majeur à l'utilisation d'un procédé d'auto-alignement par sur-gravure.

En effet, le surplomb qui permet l'auto-alignement est relativement étroit, actuellement de l'ordre de 0,2 µm.

Cette faible dimension impose que le dépôt du second contact métallique, qui est par exemple un contact de base dans le cas d'une application au transistor bipolaire, soit effectué avec une source de dépôt directive et telle que la direction des atomes déposés soit perpendiculaire à la surface du substrat en tout point de celui-ci.

Dans le cas contraire, l'angle d'incidence des atomes peut être suffisamment élevé pour que le dépôt vienne court-circuiter l'émetteur et la base du transistor.

Ce problème est résolu par l'utilisation d'un bâti du type "planétaire" ou "à carrousel".

Ceci rend très difficile l'utilisation d'une méthode de dépôt de type pulvérisation cathodique.

On considère maintenant les inconvénients des procédés d'auto-alignement par écriture électronique sur des résines de sensibilités différentes.

On notera que la lithographie électronique est plus lente que le lithographie optique.

A ce sujet, on pourra consulter le document suivant :
N. Samoto et al., Journ. Vacuum Sci. and Technol. B8(6), Nov. Dec. 1990, p.1335.

Mais d'autres inconvénients apparaissent dans les étapes de tels procédés :
- les surplombs (obtenus avec la résine de la couche supérieure, qui est la moins électro-sensible) ont une amplitude limitée, ce qui empêche l'obtention de sections importantes de contact,
- l'épaisseur du dépôt métallique en forme de T est également limitée par l'épaisseur des résines électro-sensibles utilisées, ce qui renforce l'inconvénient précédent, et la résolution ultime de la lithographie électronique est d'autant plus grande que l'épaisseur de résine est plus faible, d'où la nécessité d'un compromis,
- il est très difficile d'utiliser les techniques de pulvérisation cathodique pour déposer le métal, à cause de l'isotropie de la direction des atomes métallique lors du dépôt : les flancs des motifs de résine sont également métallisés, ce qui est très gênant.

Au sujet de ce troisième inconvénient, on consultera les articles suivants :
Topographical limitations to the metallization of very large scale integrated structures by bias sputtering : Experiments and computer simulations, H.P. Bader and M.A. Lardon, J. Vac. Sci. Technol. B4(5), Sept. Oct. 1986, p.1192
Modeling bias sputter planarization of metal films using a ballistic deposition simulation, S.K. Dew, T. Smy, R.N. Tait and M.J. Brett, J. Vac. Sci. Technol., A9(3) May-June 1991, p.519.

Les modélisations confirmées par l'expérience montrent l'importance des couvertures de flancs des motifs de résine ainsi que la formation de "vides" ("voids") à l'intérieur des dépôts, y compris pour les dépôts utilisant la technique de "bias-sputtering" (qui fait intervenir une polarisation du substrat).

Ainsi, les techniques de dépôt par pulvérisation cathodique, les plus prometteuses pour les applications à la VLSI, sont très difficiles à utiliser avec ce procédé d'auto-alignement utilisant la lithographie électronique.

Pour ces procédés, il faut donc avoir recours aux dépôts par canon à électrons ou par effet Joule.

Mais ces deux dernières techniques impliquent une dépendance de la forme du contact métallique vis-à-vis de la trajectoire des atomes destinés à former ce contact.

La présente invention a pour objet un procédé d'obtention de contacts auto-alignés d'un composant électronique, ce procédé utilisant un élément dont la section transversale est en forme de T.

Ce procédé peut être mis en oeuvre tant avec une technique de lithographie optique qu'avec une technique de lithographie électronique.

De plus, le procédé objet de l'invention permet
- d'utiliser les techniques de dépôt par pulvérisation cathodique, avec ou sans polarisation du substrat destiné à porter le composant, en s'affranchissant des inconvénients dus à la non-directivité d'un tel dépôt,
- de rendre la hauteur du T sous les branches de celui-ci et l'épaisseur du dépôt formé correspondant indépendants de la résolution souhaitée et donc de mieux maîtriser, lorsque ce dépôt est électriquement conducteur, les résistances d'accès aux zones actives des composants électroniques formés,
- de rendre la largeur des branches latérales du T indépendante des paramètres de lithographie, de développement ou de gravure susceptibles d'être utilisés dans la réalisation du contact

(en particulier pour éviter que cette largeur, qui détermine par exemple la distance entre l'émetteur et la base dans le cas d'une application aux transistors bipolaires, soit dépendante d'une sur-gravure toujours difficile à obtenir uniformément et de manière reproductible).

De façon précise, la présente invention a pour objet un procédé d'obtention de contacts électriquement conducteurs auto-alignés d'un composant électronique, ce procédé étant caractérisé en ce qu'il comprend les étapes suivantes :
- on forme, sur un substrat destiné à porter le composant, une couche appelée couche inférieure,
- on forme sur cette couche inférieure une structure dont une partie comporte une ouverture et surplombe la couche inférieure,
- on grave de façon anisotrope la couche inférieure à travers cette ouverture,
- on dépose une première couche sur l'ensemble résultant des étapes précédentes, les angles d'incidence extrêmes des atomes déposés, destinés à former cette première couche, étant symétriques par rapport à la normale à la surface du substrat en tout point de celui-ci, la couche inférieure étant apte à être éliminée isotropiquement et sélectivement par rapport à la première couche,
- on élimine ladite structure puis la couche inférieure, et
- on dépose, de façon sensiblement perpendiculaire à la surface du substrat, au moins une deuxième couche qui est électriquement conductrice et dont une partie se dépose sur le substrat et constitue un contact conducteur du composant,

un autre contact conducteur de ce composant résultant d'un dépôt électriquement conducteur, effectué préalablement au dépôt de la première couche, ou du dépôt de cette première couche alors choisie électriquement conductrice.

Ladite structure peut être formée de la façon suivante :
- on forme sur la couche inférieure une couche intermédiaire et une couche supérieure faite d'une résine choisie dans le groupe comprenant les résines photosensibles et les résines électrosensibles, la couche inférieure étant apte à être gravée anisotropiquement et sélectivement vis-à-vis de la couche supérieure, la couche intermédiaire ayant une vitesse de gravure latérale plus grande que celle de la couche supérieure,
- on crée ladite ouverture dans la couche supérieure, par sensibilisation puis développement de la couche supérieure, et
- on grave de façon isotrope la couche intermédiaire à travers cette ouverture.

Comme on le verra mieux par la suite, l'ensemble à deux couches constitué par la couche supérieure et la couche intermédiaire présente un surplomb important après la gravure isotrope de la couche intermédiaire.

La pénétration, sous ce surplomb, des atomes destinés à former ladite première couche est reliée
- au facteur de forme de l'ensemble à deux couches et
- à la pression régnant dans l'enceinte de dépôt lors du dépôt de cette première couche.

La largeur des branches du T est ainsi une fonction de cette pression et non de la sur-gravure de la couche intermédiaire.

Il est donc possible de réaliser une sur-gravure bien plus importante que ce qui est nécessaire de manière à rendre uniforme la largeur des branches du T.

Il suffit de prendre la précaution d'obtenir un surplomb au moins égal à la largeur de branche souhaitée.

Il est donc possible de tolérer une non-uniformité de la sur-gravure sur tout le substrat à condition que la plus petite sous-gravure ("undercut" dans les publications en langue anglaise) mesurée sur ce substrat ait des dimensions supérieures ou égales à la largeur recherchée pour les branches du T.

La couche intermédiaire peut être une couche de résine.

Cette couche intermédiaire peut être gravée par plasma.

Ladite couche supérieure et ladite couche intermédiaire, dont l'ensemble constitue ladite structure, peuvent être éliminées par la méthode appelée "lift-off".

Selon un premier mode de mise en oeuvre particulier du procédé objet de l'invention, ladite première couche est électriquement conductrice pour constituer ledit autre contact conducteur.

On peut déposer en outre au moins une couche électriquement conductrice sur ladite première couche qui électriquement conductrice, de façon sensiblement perpendiculaire à la surface du substrat, pour obtenir une épaisseur plus importante de matériau conducteur.

Selon un deuxième mode de mise en oeuvre particulier du procédé objet de l'invention,
- on dépose, sur ledit ensemble, une troisième couche électriquement conductrice, de façon sensiblement perpendiculaire à la surface du substrat, avant de déposer ladite première couche, cette troisième couche engendrant ledit autre contact conducteur, et
- on élimine ladite première couche après avoir déposé ladite deuxième couche.

La couche inférieure peut être faite d'un matériau diélectrique.

La gravure anisotrope de la couche inférieure peut être une gravure ionique réactive ("reactive ion etching" dans les articles en langue anglaise).

La première couche peut être déposée par pulvérisation cathodique ou par la méthode appelée "ion plating".

Avec l'invention, on peut réaliser un élément à section transversale en forme de T (susceptible de constituer un contact du composant électronique dans certains modes de mise en oeuvre du procédé objet de l'invention) dont les branches latérales ont une largeur de l'ordre de quelques dizaines de nanomètres à quelques centaines de nanomètres.

La hauteur du T sous ces branches peut aller de quelques dizaines à plusieurs centaines de nanomètres.

L'épaisseur du dépôt conduisant à ce T (par exemple obtenu par pulvérisation cathodique) peut varier entre environ 200 nanomètres et environ 500 nanomètres.

On a indiqué plus haut la condition de symétrie que doit respecter la méthode de dépôt (permettant d'obtenir le dépôt en forme de T).

On qualifie de "non directive" une méthode de dépôt satisfaisant à cette condition.

Une méthode de dépôt conduisant à une direction de dépôt sensiblement perpendiculaire à la surface du substrat (ce que permet par exemple un dispositif à carrousel) est qualifiée de "directive".

La présente invention sera mieux comprise à la lecture de la description d'exemples de réalisation donnés ci-après, à titre purement indicatif et nullement limitatif, en faisant référence aux dessins annexés sur lesquels :
· les figures 1A à 1H illustrent schématiquement des étapes d'un mode de mise en oeuvre particulier du procédé objet de l'invention permettant d'obtenir des contacts auto-alignés,
· les figures 2A et 2B illustrent schématiquement des étapes d'une variante du procédé illustré par les figures 1A à 1H, en vue d'obtenir un contact plus épais, et
· les figures 3A à 3D illustrent schématiquement des étapes d'un autre procédé conforme à l'invention.

Les figures 1A à 1H illustrent schématiquement les étapes d'un procédé conforme à l'invention, permettant d'obtenir des contacts métalliques auto-alignés sur un substrat par exemple en GaAs.

On commence par déposer sur ce substrat 2 (figure 1A) une couche diélectrique 4 de Si₃N₄ de 400 nanomètres d'épaisseur par PECVD.

Sur cette couche diélectrique 4, on dépose ensuite par centrifugation une couche 6 de résine constituée par du polyméthylméthacrylate ou PMMA.

On utilise par exemple une couche de PMMA du genre de celui qui est commercialisé par la société KTI, que l'on recuit à 170°C afin d'en évacuer les solvants (que cette résine contient initialement).

La durée de ce recuit est de 20 minutes.

Ensuite, on dépose sur cette couche 6 une couche 8 d'une résine photosensible.

On photolithographie ensuite une zone de cette résine 8 à travers un masque 10.

Dans l'exemple décrit, cette couche 8 est une couche de la résine commercialisée par la société Hoetsch sous la référence AZ4110.

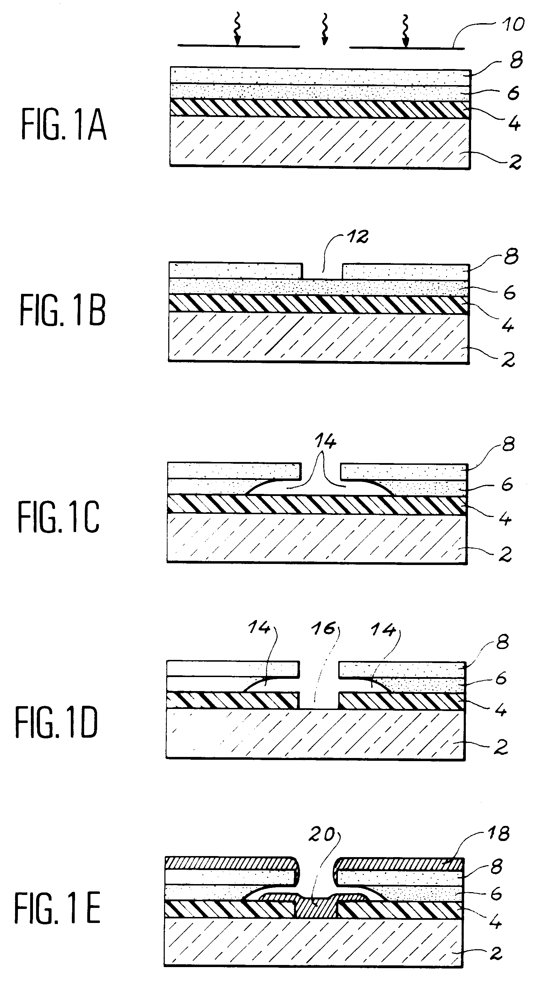

On développe ensuite la couche 8 (figure 1B).

Le substrat 2 muni des couches 4, 6 et 8 est ensuite placé dans une étuve à une température de 110°C pendant 30 minutes.

Puis ce substrat est soumis à un traitement ultraviolet de stabilisation pendant 20 minutes.

On voit sur la figure 1B l'ouverture 12 créée au niveau de la zone après développement de la couche 8.

La couche 6 de PMMA est alors gravée isotropiquement (figure 1C) dans un équipement de gravure par plasma micro-onde du type "downstream".

On utilise pour ce faire un mélange d'oxygène et de N₂O et un équipement commercialisé par la société Plasma Technology.

La durée de cette gravure est de trois minutes et conduit à une sous-gravure 14 d'environ 1 µm de profondeur sous la couche 8 de résine.

La figure 1C montre le surplomb important obtenu par cette gravure isotrope.

Ensuite, la couche 4 est gravée de manière anisotrope par gravure ionique réactive dans un plasma fluoré (figure 1D).

La couche de résine 8 sert de masque pour cette gravure anisotrope.

La figure 1D montre l'ouverture 16 ainsi obtenue dans la couche 4.

En coupe transversale, la sous-gravure 14 et cette ouverture 16 ont la forme d'un T.

L'étape suivante consiste en la métallisation du substrat 2 muni des couches 4, 6 et 8 dans un bâti de pulvérisation cathodique.

On utilise par exemple un bâti du genre de ceux qui sont commercialisés par la société Alcatel.

Cette métallisation consiste en un dépôt de 400 nanomètres de tungstène (figure 1E).

On voit sur cette figure 1E la couche de tungstène 18 formée à la surface de la couche 8.

On voit aussi le volume de tungstène 20 déposé sur le substrat, remplissant l'ouverture 16 et s'étendant dans l'espace résultant de la sur-gravure de la couche 6.

Ce volume de tungstène 20 a la forme d'un T et constitue un premier contact métallique.

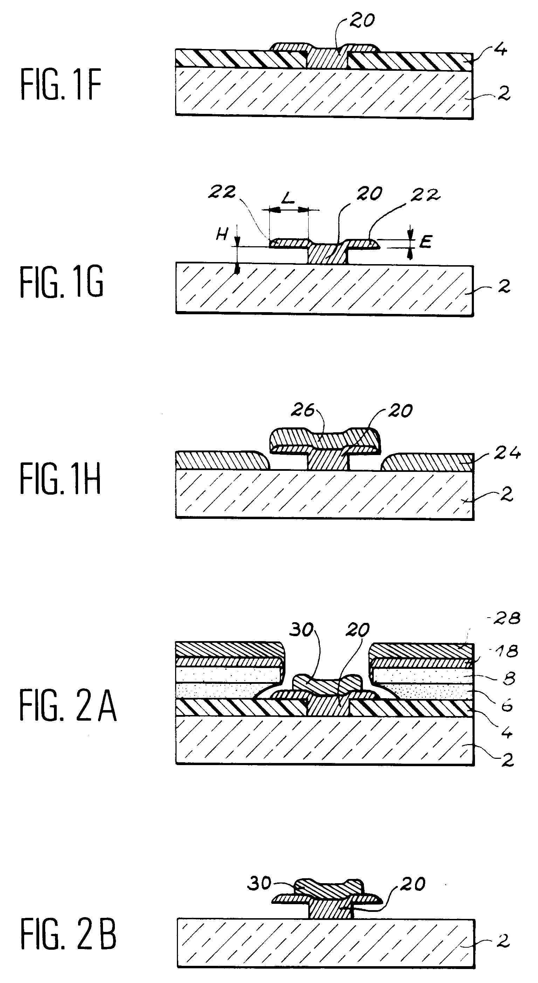

On élimine ensuite les couches 6, 8 et 18 par lift-off (figure 1F), par trempage de la structure obtenue à l'étape illustrée par la figure 1E dans un bain d'acétone pendant 10 minutes.

Ce lift-off est éventuellement accéléré par un jet d'acétone par pistolet.

Ensuite, la couche de nitrure 4 est dissoute par voie chimique (Fig.1G), par trempage de la structure obtenue (comportant le substrat 2 et le contact métallique 20 en forme de T) dans un bain d'acide fluorhydrique dilué à 50%, pendant 30 secondes.

Puis cette structure est rincée dans de l'eau désionisée.

On voit sur la figure 1G les branches latérales 22 du contact 20 en forme de T, branches dont la largeur est notée L et l'épaisseur E.

La hauteur du T sous ces branches est notée H.

On réalise ensuite (figure 1H) un autre dépôt métallique sur le substrat 2 portant le contact métallique 20.

Pour ce faire, on forme par exemple un dépôt de titane puis d'or (on pourrait aussi déposer un seul métal tel que l'or), par une méthode de dépôt directif, par exemple au moyen d'un canon à électrons ou par effet Joule.

On obtient ainsi une couche 24 de titane et d'or sur le substrat 2 et une épaisseur 26 de titane et d'or sur le contact 20.

La couche 24 constitue un deuxième contact auto-aligné avec le premier contact 20.

Ce dépôt de titane et d'or est réalisé de façon que la couche 24 ait une épaisseur inférieure à la hauteur du T sous les branches.

A titre purement indicatif et nullement limitatif, le substrat 2 comporte toutes les couches épitaxiées (non représentées) nécessaires à la réalisation d'un transistor bipolaire.

Le contact métallique 20 est destiné à constituer le contact d'émetteur de ce transistor tandis que la couche métallique 24 ultérieurement déposée est destinée à constituer le contact de base de ce transistor (après un éventuel décapage de la couche d'émetteur).

Les branches du T ont une largeur liée à la pression qui règne dans l'enceinte de dépôt par pulvérisation cathodique lors du dépôt du tungstène.

Ceci rend indépendante de la sur-gravure initiale la distance caractéristique entre les contacts auto-alignés 20 et 24.

Afin d'obtenir une résistance d'accès plus faible, il est possible d'augmenter l'épaisseur du premier dépôt (contact métallique 20), réalisé par pulvérisation cathodique, par un second dépôt directif par canon à électrons ou effet Joule.

Ceci est schématiquement illustré par les figures 2A et 2B.

La figure 2A illustre le dépôt
- d'une couche métallique 28 sur la couche 18 et
- d'une épaisseur de métal 30 sur le contact métallique 20.

Ce dépôt est effectué immédiatement après le dépôt de la couche 18 et du contact 20.

La figure 2B montre le contact métallique plus épais obtenu après l'étape de lift-off (au cours de laquelle on élimine les couches 6, 8, 18 et 28) puis l'étape d'élimination de la couche 4.

Dans ce cas, l'épaisseur de métal 30 ne participe quasiment pas à la formation des branches du T, comme on le voit sur les figures 2A et 2B.

Le procédé objet de l'invention permet de réaliser un contact métallique en forme de T ayant une bonne résistance mécanique.

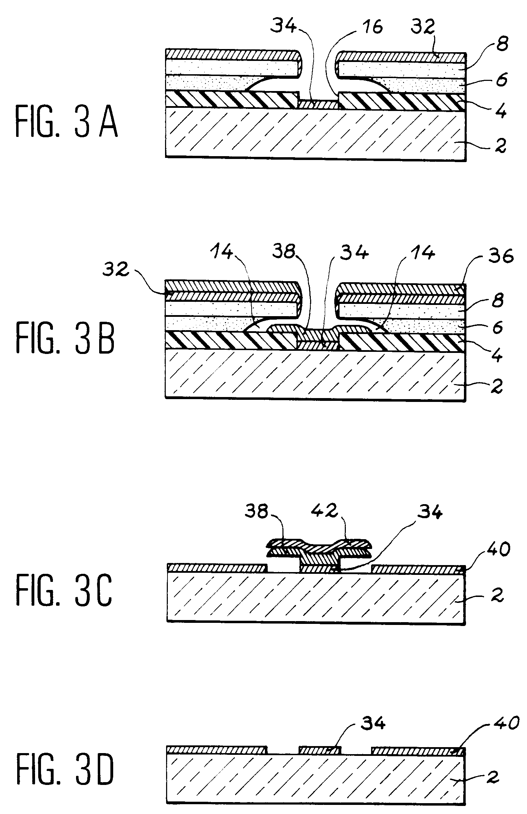

Les figures 3A à 3D illustrent schématiquement un auto-alignement de contacts utilisant un procédé conforme à l'invention :

Après avoir obtenu la structure illustrée par la figure 1D, on réalise par une méthode directive, un dépôt d'une couche métallique 32 (figure 3A) sur cette structure.

Une partie 34 de cette couche 32 est en contact avec le substrat, dans l'ouverture 16, et constitue un premier contact.

On dépose ensuite, par un procédé non directif (satisfaisant à la condition mentionnée plus haut sur la symétrie des angles extrêmes d'incidence), une autre couche 36 métallique ou diélectrique (figure 3B), dont une partie 38 se dépose sur la partie 34 et dans l'espace 14.

La partie 38 ainsi que l'ensemble des parties 34 et 38 ont, en coupe transversale, la forme d'un T.

On élimine ensuite les couches 6, 8, 32 et 36 par lift-off puis la couche 4 par attaque chimique (ou gravure sèche isotrope).

On procède ensuite à un dépôt métallique directif 40 (figure 3C) sur la structure résultant de ces éliminations.

Une partie 42 de ce dépôt 40 se trouve sur la partie 38.

On élimine ensuite les parties 38 et 42 par gravure sélective de la partie 38 vis-à-vis de la couche 40.

On obtient ainsi la structure représentée sur la figure 3D.

La partie de la couche 40, qui est en contact avec le substrat, constitue un deuxième contact métallique auto-aligné avec le contact 34.

Le dépôt de la couche 40 peut être effectué sur la couche de base, après une éventuelle élimination, par gravure, de la couche épitaxiée d'émetteur (dans le cas d'une application du procédé décrit à la réalisation d'un transistor bipolaire).

Bien entendu, au lieu d'utiliser un substrat 2 en GaAs, on pourrait utiliser un autre substrat semiconducteur par exemple en silicium.

Au lieu d'utiliser une couche de Si₃N₄ on pourrait utiliser une couche de SiO₂.

Au lieu de réaliser un dépôt métallique par pulvérisation cathodique, on pourrait réaliser un dépôt métallique par la technique appelée "ion plating".

De plus, au lieu d'utiliser une lithographie optique pour obtenir l'ouverture 12 dans la couche 8, on pourrait utiliser une lithographie électronique.

Dans ce cas, on utiliserait une résine électrosensible (et non plus photosensible) pour former cette couche 8.

Il faudrait alors recuire préalablement la couche de PMMA à une température supérieure à celle indiquée plus haut (170°C) afin de diminuer l'électro-sensibilité du PMMA.

Bien entendu, on pourrait réaliser simultanément une pluralité de contacts métalliques 20 sur le substrat 2, respectivement sur des zones choisies de celui-ci (ces zones correspondant par exemple à des composants électroniques distincts).

On utiliserait alors un masque 10 comportant une pluralité de trous en vue de photolithographier la couche 8 en regard de ces zones.

## Revendications

1. Procédé d'obtention de contacts électriquement conducteurs auto-alignés d'un composant électronique, ce procédé étant caractérisé en ce qu'il comprend les étapes suivantes :
- on forme, sur un substrat (2) destiné à porter le composant, une couche (4) appelée couche inférieure,
- on forme sur cette couche inférieure une structure (6, 8) dont une partie comporte une ouverture (12) et surplombe la couche inférieure,
- on grave de façon anisotrope la couche inférieure à travers cette ouverture,
- on dépose une première couche (18, 36) sur l'ensemble résultant des étapes précédentes, les angles d'incidence extrêmes des atomes déposés, destinés à former cette première couche, étant symétriques par rapport à la normale à la surface du substrat en tout point de celui-ci, la couche inférieure étant apte à être éliminée isotropiquement et sélectivement par rapport à la première couche,
- on élimine ladite structure puis la couche inférieure, et
- on dépose, de façon sensiblement perpendiculaire à la surface du substrat, au moins une deuxième couche (24, 40) qui est électriquement conductrice et dont une partie se dépose sur le substrat et constitue un contact conducteur du composant,
un autre contact conducteur (20, 34) de ce composant résultant d'un dépôt électriquement conducteur (32), effectué préalablement au dépôt de la première couche (36), ou du dépôt de cette première couche (18) alors choisie électriquement conductrice.

2. Procédé selon la revendication 1, caractérisé en ce que ladite structure (6, 8) est formée de la façon suivante :
- on forme sur la couche inférieure (4) une couche intermédiaire (6) et une couche supérieure (8) faite d'une résine choisie dans le groupe comprenant les résines photosensibles et les résines électrosensibles, la couche inférieure étant apte à être gravée anisotropiquement et sélectivement vis-à-vis de la couche supérieure, la couche intermédiaire ayant une vitesse de gravure latérale plus grande que celle de la couche supérieure,
- on crée ladite ouverture (12) dans la couche supérieure, par sensibilisation puis développement de la couche supérieure, et
- on grave de façon isotrope la couche intermédiaire (6) à travers cette ouverture.

3. Procédé selon la revendication 2, caractérisé en ce que la couche intermédiaire (6) est une couche de résine.

4. Procédé selon l'une quelconque des revendications 2 et 3, caractérisé en ce que la couche intermédiaire (6) est gravée par plasma.

5. Procédé selon l'une quelconque des revendications 2 à 4, caractérisé en ce que la couche supérieure (8) et la couche intermédiaire (6), dont l'ensemble constitue ladite structure, sont éliminées par la méthode appelée lift-off.

6. Procédé selon l'une quelconque des revendications 1 à 5, caractérisé en ce que ladite première couche (18) est électriquement conductrice pour constituer ledit autre contact conducteur.

7. Procédé selon la revendication 6, caractérisé en ce qu'on dépose en outre au moins une couche électriquement conductrice (28) sur ladite première couche, de façon sensiblement perpendiculaire à la surface du substrat.

8. Procédé selon l'une quelconque des revendications 1 à 5, caractérisé en ce qu'on dépose, sur ledit ensemble, une troisième couche (32) électriquement conductrice, de façon sensiblement perpendiculaire à la surface du substrat, avant de déposer ladite première couche (36), cette troisième couche engendrant ledit autre contact conducteur (34), et en ce qu'on élimine ladite première couche après avoir déposé ladite deuxième couche (40).

9. Procédé selon l'une quelconque des revendications 1 à 8, caractérisé en ce que la couche inférieure (4) est faite d'un matériau diélectrique.

10. Procédé selon l'une quelconque des revendications 1 à 9, caractérisé en ce que la gravure anisotrope de la couche inférieure (4) est une gravure ionique réactive.

11. Procédé selon l'une quelconque des revendications 1 à 10, caractérisé en ce que la première couche (18, 36) est déposée par pulvérisation cathodique.

12. Procédé selon l'une quelconque des revendications 1 à 10, caractérisé en ce que la première couche (18, 36) est déposée par la méthode appelée ion plating.
